# EUROPEAN PATENT SPECIFICATION

(11) **EP 1 963 981 B1**
(45) Date of publication and mention of the grant of the patent: **26.10.2011**
(21) Application number: 05857784.2
(22) Date of filing: 20.12.2005
(51) Int. Cl.: G06F 13/40, H05K 7/14, H04L 12/40

(54) **BACKPLANE FOR A PROGRAMMABLE LOGIC CONTROLLER**
BACKPLANE FÜR EINE PROGRAMMIERBARE LOGISCHE STEUERUNG
FOND DE PANIER POUR AUTOMATE PROGRAMMABLE

(43) Date of publication of application: 03.09.2008
(73) Proprietor: SIEMENS AKTIENGESELLSCHAFT, 80333 München (DE)
(72) Inventor: MISYUCHENKO, Igor, St. Petersburg, 199406 (RU)
(86) International application number: PCT/RU2005/000652
(87) International publication number: WO 2007/073228

(56) References cited:
- EP-A2- 0 962 867
- EP-A2- 1 477 905
- WO-A-93/15459
- WO-A-93/15464
- US-A- 5 473 757

## Description

The invention relates to a backplane for an programmable logic controller (PLC) which is provided for controlling and/or regulating a technical process. The backplane features at least one slot to accommodate a function module and switching means to be switched by at least one connection signal such that the at least one slot is connected to a signal line and/or a power line. The backplane further features a communication controller to which a communication signal can be routed via a remote device, on the basis of which communication signal the communication controller creates the at least one connection signal. In addition the invention relates to a programmable logic controller.

WO 93/15464 discloses a backplane with slots. The fact that the slots can be optionally disconnected from or connected to signal lines or power lines of a backplane bus of the backplane means that the backplane is configurable or reconfigurable. Thus, the configuration of a programmable logic controller can be changed by activating or deactivating the slots of the backplane or the modules used in these slots.

EP 0 962 867 A2 describes a method and an apparatus for operating a device bus, the bus is enabled to run at the speed of 33 or 66 MHz.

A backplane according to the precharacterizing part of claim 1 is known from WO 93/15459.

The underlying object of the present invention is to create a backplane of the type described first hereinbefore, which simplifies configuration and reconfiguration of the backplane and furthermore allows for monitoring the communication controller. In addition a programmable logic controller is to be specified which makes possible a simple activation or deactivation of modules plugged into the slots.

This object is achieved with regard to the backplane by the characterizing part cf claim 1 and with regard to the programmable logic controller by the measures specified in claim 11.

It is advantageous that it is possible for a user from a remote location, for example over the world wide Web, to exert an influence on the slots of the "active" backplane and/or on the modules of the programmable logic controller and/or the data stored in these modules. The configuration can be interrogated via the remote device, the slots or the modules can be activated or deactivated and furthermore the slots or modules can be tested and/or a restart can be undertaken via the remote device. Data of the modules can be switched or enabled, which means that access is possible to the enabled data via the backplane bus. Accordingly this data can be deactivated again, which means that it is then no longer possible to access this data via the backplane bus. The fact that the slots can be activated or deactivated through the remote device via the communication controller means that the load on the CPU of the programmable logic controller is relieved and it can be used for pure control tasks. In addition the CPU will be relieved of supervision tasks by the remote device monitoring the backplane via the communication controller. At least a part of the Web server can be stored in the communication controller, which part of the Web server is required for communication between the remote device and the communication controller. By this, both the communication load caused by a data transfer between the remote device and the communication controller and also the load on the communication controller itself are reduced.

The communication controller is monitored by an evaluation unit which switches the communication controller to passive in the event of a fault in the communication controller. The backplane bus being switched to passive allows communication via the slots which are connected to the backplane bus and equipped with function mcdules already activated. In addition a defective communication controller can be removed from the backplane in this case and replaced by a fault-free communication controller.

In one embodiment of the invention the remote device is connected via an Ethernet interface or via a slot of the backplane to the communication controller, this slot being connected to the at least one slot via a backplane bus. This makes an alternate configuration and reconfiguration of the backplane possible.

To enable a programmable logic controller equipped with this type of backplane to be expanded in a simple manner, e.g. to handle a more complex automation task, the communication controller can be connected to at least one communication controller of another such backplane. This enables the number of activatable slots into which further function modules can be plugged to be increased.

The invention allows an asynchronous buffered exchange of data between the function modules and/or the CPU module of the programmable logic controller. Furthermore, the load on the CPU modules is reduced and short response times in the communication between the remote device and the communication controller or the function modules are achieved. The opportunity is provided to pre-process the data of the modules and/or the data of further modules or devices connected to the backplane. A common timer for essential components arranged on the backplane, e.g. for the communication controller or the three-state bus buffer, records the time at which an event occurs. This time is stored together with the event in the buffer. This means that, in the event of a fault in the backplane, it its easier to analyze the error, with the backplane for example being able to be analyzed from the remote device independently of the CPU module of the programmable logic controller. The slots can be connected individually to the backplane bus which allows the function modules plugged into the slots to be activated successively, meaning that the modules can be booted up individually.

Further advantageous embodiments of the invention emerge from the further subclaims.

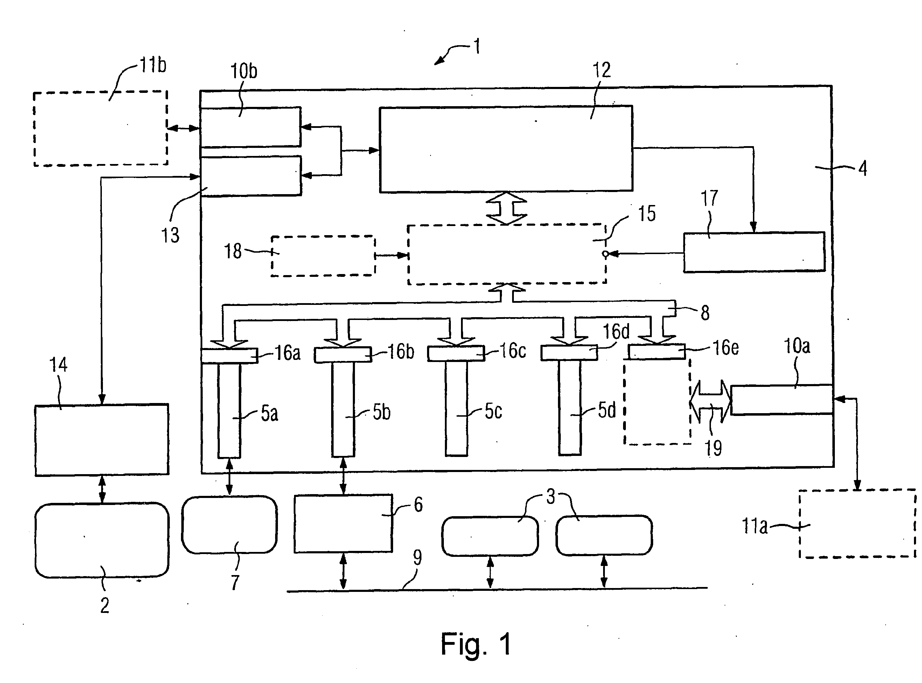

The invention will be described below in more detail on the basis of an exemplary embodiment shown in the single figure of the drawing.

In the figure of the drawing, which shows a schematic diagram of an automation unit 1 designates an automation system featuring a programmable logic controller (PLC), a remote device 2 and further intelligent input/output units 3. Components of the PLC are an active backplane 4 equipped with a number of slots 5a, 5b, ... and a number of function modules, e.g, a CPU module 6, an input/output module 7, a communication module not shown here or other modules suitable for operating the PLC. The slots 5a, 5b, ..., which are connected via a backplane bus 8 featuring one or more signal lines and/or power supply lines, are provided to accommodate the function modules and feature connecting means by which an effective electrical and mechanical connection is made to corresponding connecting means of the function modules. The CPU module 6 is connected via a communication connection (link) 9 to the intelligent input/output units 3. These intelligent input/output units are able to trigger control or automation tasks in the lower and mid performance range independently of the programmable logic controller.

It should be understood that the automation unit 1 can be provided with more than one programmable logic controller and/or remote device. In this case the remote devices comprise for example personal computers known per se, each equipped with suitable Internet browsers. To enable the automation system 1 to be expanded with further programmable logic controllers, the backplane 4 features suitable connections 10a, 10b to which backplanes 11a, 11b of the further automation units can be connected. Of course, it is also possible to connect other suitable components of an automation unit to these connections 10a, 10b.

In addition to the slots 5a, 5b, ... connected via the backplane bus 8, the backplane 4 features a communication controller 12 equipped with a Web server which is connected via a communication port 13 and a communication connection 14 to the remote device 2. The communication port 13 is embodied as an Internet interface and the communication connection (link) 14 such as the Internet or World Wide Web. Furthermore the backplane 4 is provided with a FIFO buffer and a 3-state bus buffer 15 (read, write, off) featuring a bus driver through which the communication controller 12 can be controlled and which is connected via the backplane bus 8 to electronic adjustment means 16a, 16b, ..., e.g. in the form of "electronic contactors" which are known per se, of the slots 5a, 5b, .... In addition the backplane 8 features an evaluation unit 17 and a timer 18 which is provided especially for recording the time of the occurrence of an event. Of course, the timer 18 can be provided for time recording for further elements arranged on the backplane 4. The evaluation unit 17 monitors the communication controller 12, with in the case of a fault in the communication controller 12, the evaluation unit 17 switching the communication controller 12 to passive. In this case the backplane bus 8 is switched to passive and communication is possible between the function modules which are plugged into the slots 5a, 5b, ... already activated by the communication controller 12 before the fault. The evaluation unit 17 can of course be a component of the communication controller 12.

As shown in the exemplary embodiment, only the terminal 10b is directly connected to the communication controller 12 whereas the port 10a is connected to the communication controller 12 via a further bus 19 of the backplane 4, a bus buffer 20, the backplane bus 8 and via the three-state bus buffer 15.

The function and method of operation of the automation system 1 with regard to the activation of a slot 5a, 5b, ... is explained in greater detail below. It is assumed here that the slot 5c is to be connected to a data line for example. To this end the remote device 2 initially transfers a corresponding communication signal to the communication controller 12 via the communication connection (link) 14 and the communication port 13. The communication controller 12 evaluates the communication signal and detects that one of a number of lines of the backplane bus 8 is to be connected to the slot 5c. Thereupon the communication controller 12 creates a suitable connection signal through which, via the three-state bus buffer 15, the adjusting means 16c is switched such that the data line is coupled to the slot 5c. This means that this data line is connected to the slot 5c and a communication with a function module plugged in at this slot 5c can take place via this data line. By means of further suitable communication signals it is possible to connect further data, address and/or power lines to the slot 5c. For example all address, all data or all power lines can be connected to slot 5c through a corresponding communication signal. A further communication signal can be provided, the effect of which is to connect groups or all address, data and power lines to slot 5c. Communication signals are also provided which enable each individual line, a group of lines or all lines to be disconnected from slot 5c.

All components of the communication controller 12, e.g. a microprocessor, TCP/IP stack, ..., are implemented in the form of "electronic panels" and provided with "planar cut-off connectors" or "flat cut-off connectors" known per se, thus allowing the communication controller 12 to be easily removable from the backplane 4. This allows defective communication controllers to be easily exchanged.

## Claims

1. Backplane for a programmable logic controller, which is provided for control and/or regulation of a technical process, the backplane (4) being equipped with a backplane bus (8) and
- featuring at least one slot (5a, 5b, ...) for accommodating a function module (6, 7),
- featuring switching means (15, 16a, 16b, ...), the switching means (15, 16a, 16b, ...) being switched by at least one connection signal such that the at least one slot (5a, 5b, ...) is connected to at least one signal line and/or to at least one power line, and
- further featuring a communication controller (12) to which a communication signal can be routed via a remote device (2), on the basis of which communication signal the communication controller (12) creates the at least one connection signal,
**characterized in that** an evaluation unit (17) is provided for monitoring the communication controller (12), the evaluation unit (17) switching the communication controller (12) to passive in the event of a communication controller (12) fault.

2. Backplane in accordance with claim 1, **characterized in that** further slots (5a, 5b, ...) for accommodating function modules (6, 7) are provided, the function modules (6, 7) being communication modules and/or CPU modules (6) and/or input and/or output modules (7).

3. Backplane in accordance with claim 1 or 2, **characterized in that** the remote device (2) is connected via an Ethernet interface (13) to the communication controller (12).

4. Backplane in accordance with claim 2, **characterized in that** the remote device (2) is connected via a communication module to the communication controller (12).

5. Backplane in accordance with one of the claims 1 to 4, **characterized in that** the communication controller (12) can be connected to at least one communication controller of a further backplane.

6. Backplane in accordance with one of the claims 2 to 5, **characterized in that** the communication controller (12) is connected via a three-state bus buffer (15) to the backplane bus (8), the buffer (15) being provided with a FIFO memory.

7. Backplane in accordance with claim 6, **characterized in that** each event is stored in the FIFO memory along with the time of the occurrence of the event concerned.

8. Backplane in accordance with claim 6 or 7, **characterized in that** the communication controller (12) accesses the FIFO memory asynchronously and independently of the operation of the CPU module (6).

9. Backplane in accordance with one of the claims 1 to 7, **characterized in that** at least a part of a Web server which is required for communication between the remote device (2) and the communication controller (12) can be stored in the communication controller (12).

10. Backplane in accordance with one of the claims 1 to 9, **characterized in that** the backplane (4) features at least one port (10a, 10b) for connecting a further bus system or a further device, especially an HMI device.

11. Programmable logic controller with a backplane in accordance with one of the claims 1 to 10.

## Patentansprüche

1. Rückwandplatine für ein Automatisierungsgerät, welches zum Steuern und/oder Regeln eines technischen Prozesses vorgesehen ist, wobei
- die mit einem Rückwandbus (8) versehene Rückwandplatine (4) mindestens einen Steckplatz (5a, 5b, ...) zur Aufnahme einer Funktionsbaugruppe (6, 7) und Schaltmittel (12, 15, 16a, 16b, ...) aufweist,
- die Schaltmittel (12, 15, 16a, 16b, ...) durch mindestens ein Verbindungssignal derart schaltbar sind, dass der mindestens eine Steckplatz (5a, 5b, ...) mit mindestens einer Signal- und/oder mindestens einer Versorgungsleitung verbunden ist,
- die Rückwandplatine (4) einen Kommunikations-Controller (12) aufweist, welchem über eine Remote-Vorrichtung (2) ein Kommunikationssignal zuführbar ist, aufgrund dessen der Kommunikations-Controller (12) das mindestens eine Verbindungssignal erzeugt,
**dadurch gekennzeichnet, dass** eine Auswerteeinheit (17) zur Überwachung des Kommunikations-Controllers (12) vorgesehen ist, wobei im Falle einer Störung des Kommunikations-Controllers (12) die Auswerteeinheit (17) den Kommunikations-Controller (12) passiv schaltet.

2. Rückwandplatine nach Anspruch 1, **dadurch gekennzeichnet, dass** weitere Steckplätze (5a, 5b, ...) zur Aufnahme von Funktionsbaugruppen (6, 7) vorgesehen sind, wobei die Funktionsbaugruppen (6, 7) eine Kommunikations-Baugruppe und/oder eine CPU-Baugruppe (6) und/oder eine Ein- und/oder Ausgabebaugruppe (7) sind.

3. Rückwandplatine nach Anspruch 1 oder 2, **dadurch gekennzeichnet, dass** die Remote-Vorrichtung (2) über eine Ethernet-Schnittstelle (13) mit dem Kommunikations-Controller (12) verbunden ist.

4. Rückwandplatine nach Anspruch 2, **dadurch gekennzeichnet, dass** die Remote-Vorrichtung (2) über eine Kommunikations-Baugruppe mit dem Kommunikations-Controller (12) verbunden ist.

5. Rückwandplatine nach einem der Ansprüche 1 bis 4, **dadurch gekennzeichnet, dass** der Kommunikations-Controller (12) mit mindestens einem Kommunikations-Controller einer weiteren Rückwandplatine verbindbar ist.

6. Rückwandplatine nach einem der Ansprüche 2 bis 5, **dadurch gekennzeichnet, dass** der Kommunikations-Controller (12) über einen Three-state-bus-Buffer (15) mit dem Rückwandbus (8) verbunden ist, wobei der Buffer (15) mit einem FIFO-Speicher versehen ist.

7. Rückwandplatine nach Anspruch 6, **dadurch gekennzeichnet, dass** in dem FIFO-Speicher jedes Ereignis mit dem Zeitpunkt des Auftretens des jeweiligen Ereignisses hinterlegt wird.

8. Rückwandplatine nach Anspruch 6 oder 7, **dadurch gekennzeichnet, dass** der Kommunikations-Controller (12) asynchron und unabhängig von der Operation der CPU-Baugruppe (6) auf den FIFO-Speicher zugreift.

9. Rückwandplatine nach einem der Ansprüche 1 bis 7, **dadurch gekennzeichnet, dass** in dem Kommunikations-Controller (12) zumindest ein Teil eines Webservers hinterlegbar ist, welcher für eine Kommunikation zwischen der Remote-Vorrichtung (2) und dem Kommunikations-Controller (12) erforderlich ist.

10. Rückwandplatine nach einem der Ansprüche 1 bis 9, **dadurch gekennzeichnet, dass** die Rückwandplatine (4) mindestens einen Anschluss (10a, 10b) zum Anschluss eines weiteren Bussystems oder eines weiteren Gerätes, insbesondere eines HMI-Gerätes, aufweist.

11. Automatisierungsgerät mit einer Rückwandplatine nach einem der Ansprüche 1 bis 10.

## Revendications

1. Fond de panier pour un automate logique programmable qui est prévu pour la commande et/ou la régulation d'un processus technique, le fond de panier ( 4 ) étant équipé d'un bus ( 8 ) de fond de panier et
- présentant au moins une fente ( 5a, 5b, ... ) pour loger un module ( 6, 7 ) de fonction,
- présentant des moyens ( 15, 16a, 16b, ... ) de commutation, les moyens ( 15, 16a, 16b, ... ) de commutation étant commutés par au moins un signal de connexion de manière à ce que la au moins une fente ( 5a, 5b, ... ) soit reliée à au moins une ligne d'acheminement de signaux et/ou à au moins une ligne électrique, et
- présentant en outre un automate ( 12 ) de communication auquel un signal de communication peut être acheminé par l'intermédiaire d'un télédispositif ( 2 ) sur la base du signal de communication duquel l'automate ( 12 ) de communication crée le au moins un signal de connexion, **caractérisé en ce qu'**il est prévu une unité ( 17 ) d'évaluation pour contrôler l'automate ( 12 ) de communication, l'unité ( 17 ) d'évaluation commutant 1"automate ( 12 ) de communication pour qu'il devienne passif dans le cas d'une défaillance de l'automate ( 12 ) de communication.

2. Fond de panier suivant la revendication 1, **caractérisé en ce qu'**il est prévu d'autres fentes ( 5a, 5b, ... ) pour loger des modules ( 6, 7 ) de fonction, les modules ( 6, 7 ) de fonction étant des modules de communication et/ou des modules ( 6 ) de CPU et/ou des modules ( 7 ) d'entrée et/ou de sortie.

3. Fond de panier suivant la revendication 1 ou 2, **caractérisé en ce que** le télédispositif ( 2 ) est relié à l'automate ( 12 ) de communication par une interface ( 13 ) éthernet.

4. Fond de panier suivant la revendication 1 ou 2, **caractérisé en ce que** le télédispositif ( 2 ) est relié à l'automate ( 12 ) de communication par un module de communication.

5. Fond de panier suivant l'une des revendications 1 à 4, **caractérisé en ce que** l'automate ( 12 ) de communication peut être relié à au moins un automate de communication d'un autre fond de panier.

6. Fond de panier suivant l'une des revendications 2 à 5, **caractérisé en ce que** l'automate ( 12 ) de communication est relié, par un tampon ( 15 ) de bus à trois états, au bus ( 8 ) de fond de panier, le tampon ( 15 ) étant pourvu d'une mémoire FIFO.

7. Fond de panier suivant la revendication 6, **caractérisé en ce que** chaque évènement est mémorisé dans la mémoire FIFO en même temps que l'instant de l'apparition de l'évènement concerné.

8. Fond de panier suivant la revendication 6 ou 7, **caractérisé en ce que** l'automate ( 12 ) de communication accède à la mémoire FIFO de manière asynchrone et indépendamment du fonctionnement du module de CPU.

9. Fond de panier suivant l'une des revendications 1 à 7, **caractérisé en ce qu'**au moins une partie d'un serveur de toile, qui est nécessaire pour une communication entre le télédispositif ( 2 ) et l'automate ( 12 ) de communication, peut être mémorisée dans l'automate ( 12 ) de communication.

10. Dispositif de filtration suivant l'une des revendications 1 à 9, **caractérisé en ce que** le fond de panier ( 4 ) présente au moins un accès ( 10a, 10b ) pour connecter un autre système de bus ou un autre dispositif, en particulier un dispositif HMI.

11. Automate logique programmable ayant un fond de panier suivant l'une des revendications 1 à 10.
